(19) Europäisches Patentamt
European Patent Office
Office européen des brevets

(11) **EP 0 634 005 B1**

(12) **EUROPÄISCHE PATENTSCHRIFT**

(45) Veröffentlichungstag und Bekanntmachung des Hinweises auf die Patenterteilung:
**22.10.1997 Patentblatt 1997/43**

(21) Anmeldenummer: **94906220.2**

(22) Anmeldetag: **04.02.1994**

(51) Int Cl.⁶: **G01J 5/06**

(86) Internationale Anmeldenummer:
**PCT/EP94/00322**

(87) Internationale Veröffentlichungsnummer:
**WO 94/18530 (18.08.1994 Gazette 1994/19)**

(54) **INFRAROT-STRAHLENDETEKTOREINRICHTUNG**

INFRARED RADIATION DETECTOR

DETECTEUR AUX INFRAROUGES

(84) Benannte Vertragsstaaten:
**DE FR GB IT NL**

(30) Priorität: **04.02.1993 DE 4303231**

(43) Veröffentlichungstag der Anmeldung:
**18.01.1995 Patentblatt 1995/03**

(73) Patentinhaber: **BRITISH AEROSPACE PUBLIC LIMITED COMPANY**
**Farnborough, Hants. GU14 6YU (GB)**

(72) Erfinder:
• **THOMA, Christoph**
  **D-85716 Unterschleissheim (DE)**

• **ERDMANN, Matthias**
  **D-80333 München (DE)**
• **SCHWEIGER, Johann**
  **D-85354 Freising (DE)**
• **PIETZSCH, Karl**
  **D-82538 Geretsried (DE)**

(74) Vertreter: **Pätzold, Herbert, Dr.-Ing.**
**Steubstrasse 10**
**82166 Gräfelfing (DE)**

(56) Entgegenhaltungen:
**EP-A- 0 044 791          EP-A- 0 403 880**
**DE-A- 3 716 358**

**Beschreibung**

Die Erfindung bezieht sich auf eine Infrarot-Strahlendetektoreinrichtung gemäß dem Oberbegriff des Anspruches 1.

Durch die DE-37 16 358 C2 (= EP-0 290 751 A2) ist eine Infrarot-Strahlendetektoreinrichtung bekannt, die ein gekühltes Dewar aufweist, in dem sich ein Infrarotempfänger, vorzugsweise ein flächiges Detektorelement (focal plane array) befindet und das zur Infrarot-Optik (IR-Optik) ein durch ein für Infrarotstrahlen durchlässiges IR-Fenster verschlossen ist. Das Dewar besteht aus einem an ein Vakuum angeschlossenes Gehäuse, das nach außen von dem IR-Fenster abgeschlossen ist. Innerhalb des Gehäuses befindet sich gegenüber dem IR-Fenster ein an eine Kühleinrichtung angeschlossenes inneres Kälteschild, das eine innere Kaltblende umfaßt und dessen gekühlte Bodenwand als Träger des flächigen Detektorelements dient. Dem Dewar ist in Lichtrichtung ein von der Kühleinrichtung thermisch getrenntes äußeres Kälteschild vorgeschaltet, das derart ausgebildet und gegenüber dem inneren Kälteschild derart angeordnet ist, daß die Öffnung der inneren Kaltblende durch das äußere Kälteschild in sich selbst abgebildet wird. Dabei ist das äußere Kälteschild beispielsweise als innenverspiegelter Hohlspiegel mit einer eine äußere Kaltblende bildenden Öffnung ausgebildet, wobei der Krümmungsmittelpunkt im Zentrum der Öffnung der inneren Kaltblende liegt. Dieser Stand der Technik vermittelt noch keine allgemeine Lehre, mit konstruktiv einfachen Mitteln den Aufwand für die zu erbringende Kühlleistung für das innere Kälteschild auf ein vergleichsweise wesentlich niedrigeres Niveau zu bringen.

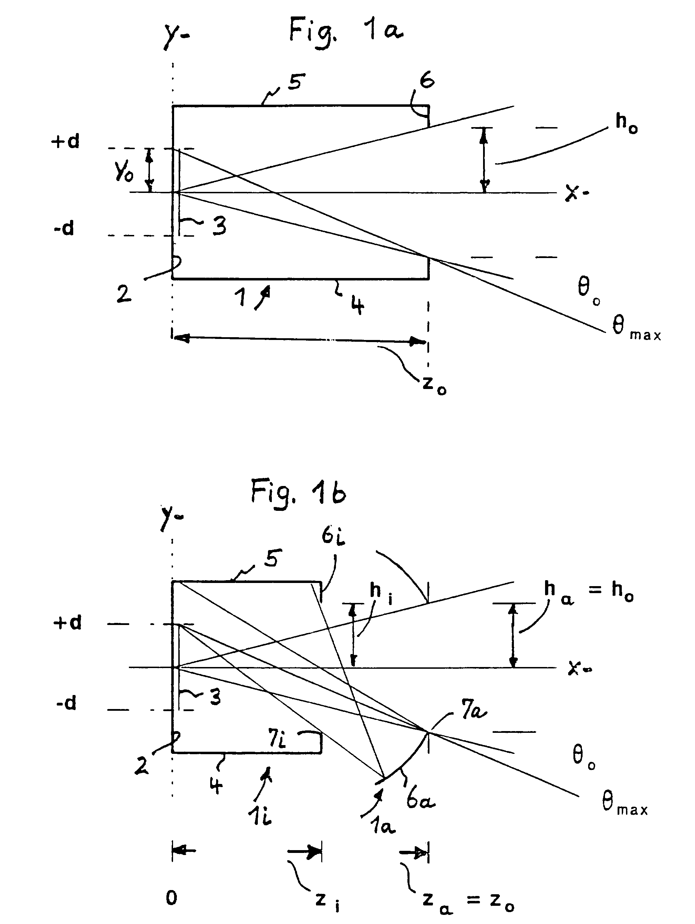

Das bekannte Kälteschild ist ohne das Dewar und das äußere Kälteschild in einer schematischen Skizze in Fig. la der beigefügten Zeichnung mit 1 bezeichnet. An die gekühlte Bodenwand 2 als Träger des Detektorelements 3 schließen Seitenwände 4 und 5 an, die gekühlt sein können. Die Kühleinrichtung ist gleichfalls nicht dargestellt. Im Abstand $z_o$ von der Bildebene an der Oberfläche des Detektorelements 3 befindet sich die innere Kaltblende 6 mit einer zentralen Öffnung 7. Die Kaltblende 6 schließt an die gekühlten Seitenwände 4 und 5 an, und kann ebenfalls gekühlt sein. Die Öffnung 7 der Kaltblende 6 besitzt eine gewählte Randhöhe $h_o$ von der optischen Achse x. Die gekühlte Bodenwand 2 mit den anschließenden Seitenwänden 4 und 5 und der zwischen ihnen gehaltenen Kaltblende 6 bilden gemeinsam das gekühlte Kälteschild 1 innerhalb eines nicht dargestellten an eine Vakuumvorrichtung angeschlossenen Dewars. Das Kaltblendenöffnungsverhältnis $k_o$ ist durch $z_o/2h_o$ bestimmt, wobei $z_o$ der Abstand der Öffnung 7 der Kaltblende 6 von der Bildebene und $h_o$ die Randhöhe $h_o$ der Kaltblende ist. Die Bildhöhe $y_o$ auf der Oberfläche des Detektorelements 3 ist maximal ± d. Die innere Kaltblende 6 bildet dabei die Aperaturblende und stellt die Austrittspupille der nicht-gezeigten IR-Optik dar. Das durch den eingangs genannten Stand der Technik bekannte äußere Kälteschild ist in Fig. 1a ebenfalls nicht dargestellt, da es ohne jeden Einfluß auf die räumliche Ausbildung des Dewar bzw. des inneren Kälteschildes ist.

Übliche flächige Detektorelemente in bekannten Kälteschilden arbeiten mit einem Kaltblendenöffnungsverhältnis $z_o/2h_o$ von 1 bis 3.

Um die vorgeschaltete IR-Optik mit minimaler optischer Öffnung (minimaler optischer Aufwand, minimale Aberation) auslegen zu können, ist beim gebräuchlichen Stand der Technik (Fig. 1a) notwendigerweise ein relativ großer Abstand $z_o$ zwischen der Bildebene auf der Oberfläche des flächigen Detektorelementes 3 und der inneren Kaltblende 6 zu wählen, die die Aperaturblende bildet und die Austrittspupille der IR-Optik darstellt, denn je kürzer der Abstand $z_o$ zwischen der Bildebene und der Kaltblende 6 ist, umso größer ist der Winkel $\theta$ zwischen dem Strahlenbüschel der Randpunkte des Detektorelementes und der optischen Achse. Das führt zu Gewichts-, Volumen- und Preisnachteilen aufgrund der großen Linsendurchmesser der IR-Optik. Bei minimaler optischer Öffnung der IR-Optik ist in der Praxis bei einem optimalen Winkel $\theta_{opt}$ der minimale Abstand zwischen der Bildebene und der Kaltblende daher auf etwa den 2-fachen diagonalen Durchmesser des flächigen Detektors begrenzt, will man nicht Vignettierung der Optik oder einen schlechten inneren KälteschildWirkungsgrad in Kauf nehmen. Bei modernen großflächigen IR-Detektorelementen führt das zu einem entsprechend großvolumigen inneren Kälteschild bzw. zu einem entsprechend großen Dewar. Die zu erbringende Kälteleistung der an das innere Kälteschild angeschlossenen Kühleinrichtung ist somit beträchtlich.

Aufgabe der Erfindung ist es daher, eine konstruktiv weitgehend einfach ausgebildete Infrarot-Strahlendetektoreinrichtung der eingangs genannten Art für eine vorgeschaltete IR-Optik mit minimaler optischer Öffnung bei einem optischen Öffnungsverhältnis $k_{opt}$ von $1/2\cot(\theta_{max})$ anzugeben, bei der bei weitgehend großem Durchmesser des flächigen Detektorelementes der räumliche und bauliche Aufwand für das Dewar mit einer vignettierungsfreien Strahleneintrittsöffnung vergleichsweise klein und in der optischen Achse wesentlich kürzer als beim Stand der Technik ausgebildet ist, so daß auch der Aufwand für die zu erbringende Kühlleistung auf ein weitgehend niedrigeres Niveau gedrückt werden kann. Dabei soll auch die Möglichkeit eröffnet sein, das innere Kälteschild extern vom Detektorelement anzuordnen, um dadurch eine größere Flexibilität des verwendeten Detektor/Dewar-Systems gegenüber dem Stand der Technik zu erhalten.

Die vorstehende Aufgabe der Erfindung wird mit den Merkmalen des Anspruches 1 gelöst. Vorteilhafte Ausführungen ergeben sich aus der Beschreibung und/oder den Merkmalen der abhängigen Ansprüche. Hierdurch werden dem Fachmann allgemeine Regeln für vignettierungsfreie Kälteschild-Einrichtungen mit hohem KälteschildWirkungsgrad an die Hand gegeben, die auch die Möglichkeit zum einfachen Umbau bekannter Einrichtungen eröffnen, um mit geringem Aufwand in den Genuß der erfindungsgemäßen Vorteile zu gelangen. Im Vergleich mit dem relevanten Stand der Technik kann bei identischen optischen Verhältnissen erfindungsgemäß der Abstand der Öffnung der inneren Kaltblende von dem flächigen Detektorelement (focal plane array) wesentlich zurückgenommen werden (beispielsweise auf 2/3 des Abstandes oder weniger, der nach dem Stand der Technik gegeben ist). Der Abstand der inneren Kaltblende von dem Detektorelement kann damit vergleichsweise gering gehalten werden.

Die Forderung der Vignettierungsfreiheit bei hohem Kälteschildwirkungsgrad wird erfindungsgemäß durch Bedingungen sichergestellt, die nachstehend anhand einer Skizze in Fig. 1b der Zeichnung erläutert sind.

Gleiche bzw. entsprechende Teile in den Fig. 1a und 1b sind mit den gleichen Bezugszeichen versehen. Dabei sind die Skizzen in den Fig. 1a und 1b im gleichen Maßstab fluchtend untereinander gezeichnet, um dadurch den Vergleich der Erfindung (Fig. 1b) mit dem Stand der Technik (Fig 1a) zu erleichtern.

Im Unterschied zum Stand der Technik nach Fig. 1a ist in Fig. 1b dem inneren Kälteschild $1_i$ mit einer inneren, die Aperaturblende bildenden Kaltblende $6_i$ und einer Kaltblendenöffnung $7_i$ ein äußeres Kälteschild $1_a$ vorgeschaltet, das hier aus einer äußeren Kaltblende $6_a$ mit einer Öffnung $7_a$ und einem äußeren Kaltblendenöffnungsverhältnis $k_a = z_a/2h_a$ besteht, das dem Kaltblendenöffnungsverhältnis $z_o/2h_o$ in Fig. 1a entspricht, wobei $z_a$ der Abstand der Öffnung $7_a$ der äußeren Kaltblende $1_a$ von der Bildebene und $h_a$ die Höhe der äußeren Kaltblendenöffnung $7_a$ ist. Die äußere Kaltblende $6_a$, die erfindungsgemäß die Aperaturblende bildet, ist im Beispielsfalle als innenverspiegelter Hohlspiegel ausgebildet. Das innere Kaltblendenöffnungsverhältnis $k_i$ der inneren Kaltblende $6_i$ des inneren Kälteschildes $1_i$ ist entsprechend durch $z_i/2h_i$ bestimmt, wobei $z_i$ der Abstand der Öffnung $7_i$ der inneren Kaltblende $6_i$ von der Bildebene und $h_i$ die Höhe der inneren Kaltblendenöffnung $7_i$ ist. Wie in Figur 1a ist die Bildhöhe $y_o$ in der Detektorebene maximal $\pm$ d (Der maximale Gesamtdurchmesser des flächigen Detektorelementes beträgt 2d), und bei minimaler optischer Öffnung der vorgeschalteten IR-Optik ist das Öffnungsverhältnis der Optik $k_{opt} = 1/2 \cot(\theta_{max})$. Zum besseren Verständnis sind die Verhältnisse in den beiden Einrichtungen nach Fig. 1a und 1b so gewählt, daß die Winkel $\theta_{max}$ gleichgroß sind.

Zur weiteren Verdeutlichung der Erfindung ist in den Fig. 1a und 1b der Abstand der Aperturblende (in Fig. 1a die innere Kaltblende 6 und in Fig. 1b die äußere Kaltblende 6a) von der Bildebene jeweils gleich ausgebildet, d.h. $z_o = z_a$.

Die in der nachstehenden Berechnung verwendeten Parameter für eine erfindungsgemäße Einrichtung werden nachfolgend nochmals zusammengefaßt:

$\theta$ = Winkel zwischen dem Strahlenbüschel der Randpunkte des Detektorelementes und der optischen Achse

$k_{opt}$ = Öffnungsverhältnis der Optik $1/2 \cot(\theta_{max})$

$k_a$ = äußeres Kaltblendenöffnungsverhältnis $z_a/2h_a$

$k_i$ = inneres Kälteschild-Öffnungsverhältnis $z_i/2h_i$

$z_a$ = Abstand Bildebene - äußere Kaltblendenöffnung $7_a$

$z_i$ = Abstand Bildebene - innere Kaltblendenöffnung $7_i$

$y_o$ = Bildhöhe in der Detektorebene (max in der Bildhöhe = $\pm$ d)

$h_a$ = Randhöhe der äußeren Kaltblendenöffnung $7_a$

$h_i$ = Randhöhe der inneren Kaltblendenöffnung $7_i$

$NA$ = numerische Apertur

Für die abbildenden Randstrahlen der Bildmitte (beide unter $\theta_o$) gilt die Funktion (Geradengleichung)

$$g_o(x) = \pm \frac{h_a}{z_a} \cdot x \qquad (1)$$

außerdem gilt

$$NA := \sin\theta_o$$

und

$$k_a := \frac{z_a}{2h_a} \left(= \frac{1}{2 tg\theta_o}\right)$$

Für die Randstrahlen zum Bildrand (maximale Bildhöhe, maximales Büschel) gilt die Funktion (Geradengleichung)

$$g_d(x) = -\frac{d \pm h_a}{z_a} \cdot x + d. \qquad (2)$$

Dabei bedeutet die erste Bedingung $(d+h_a)_{max}$ Winkel $\theta_{max}$ und die zweite Bedingung $(d-h_a)$ bedeutet die Randbedingung für $h_i$ Zur ersten Bedingung:

$$k_{opt} = \frac{1}{2 tg\theta_{max}} = \frac{z_a}{2(d + h_a)}$$

oder

$$\frac{1}{k_{opt}} = \frac{2d}{z_a} + \frac{2h_a}{z_a}$$

Da

$$\frac{2h}{z_a} = \frac{1}{k_a}$$

ist folgt

$$\frac{1}{k_{opt}} = \frac{2d}{z_a} + \frac{1}{k_a}$$

zur zweiten Bedingung : (Bestimmung der inneren Kaltblende)

$$g_d(x) = - \frac{d-h_a}{z_a} \cdot x + d$$

Mit der Forderung der Vignettierungsfreiheit gilt (symmetrisch zur optischen Achse)

$$h_i \geq g_d \ (x = z_i) \tag{3}$$

$$h_i \geq - \frac{d-h_a}{z_a} \cdot z_i + d,$$

$$h_i \geq + d - \frac{z_i}{z_a} \cdot d + h_a \cdot \frac{z_i}{z_a}$$

und

$$h_i \geq d \cdot (1 - \frac{z_i}{z_a}) + h_a \cdot \frac{z_i}{z_a}$$

Für das benötigte Öffnungsverhältnis der vorgeschalteten Optik gilt, wie oben gezeigt,

$$\frac{1}{k_{opt}} = \frac{2d}{z_a} = \frac{1}{k_a} \tag{4}$$

Die nachstehenden Gleichungen (5) beschreiben den Zusammenhang zwischen einem optimal kleinstmöglichen (effektivsten) inneren Kälteschild-Öffnungsverhältnis $k_i$ und dem optimal kleinstmöglichen Abstand $z_i$ zwischen Bildebene (Detektorfläche) und der inneren Kalteblende $6_i$ bei maximaler Bildhöhe $y_o = d$ in der Detektorebene und bei einem maximalen Öffnungsverhältnis $k_a$ der äußeren Kaltblende, die die Austrittspupille für die vorgeschaltete Optik bildet

$$\frac{1}{2k_i} \geq \frac{1}{2k_a} + (\frac{1}{z_i} - \frac{1}{z_a}) \cdot d \tag{5}$$

Dies folgt aus

$$\frac{h_i}{z_i} \geq d \ (\frac{1}{z_i} - \frac{1}{z_a}) + \frac{h_a}{z_a}$$

wobei

$$\frac{h_i}{z_i} = \frac{1}{2k_i} \quad \text{und} \quad \frac{h_a}{z_a} = \frac{1}{2k_a}$$

Die Randbedingungen für die Abstände $z_a$ in $z_i$ sind durch die folgende Beziehung bestimmt

$$z_i \geq 1/2 \ z_a \tag{6}$$

In der Gegenüberstellung der beiden Skizzen (Fig. 1a = Stand der Technik; Fig. 1b = Erfindung) sind $z_a = z_o$, $h_a = h_o$, $h_i = h_o$ und $z_i \sim 1/2 \ z_o$.

Die Erfindung wird anhand von Ausführungsbeispielen in schematischer Darstellung beschrieben. In der zugehörigen Zeichnung zeigt:

Figur 1a      eine vorstehend beschriebene Skizze einer Kälteschildanordnung nach dem Stand der Technik in einer prinzipiellen Darstellung;

Figur 1b      eine vorstehend ebenfalls beschriebene Skizze einer erfindungsgemäßen Kälteschildanordnung in einer vergleichbaren Darstellung zu Fig. 1a;

Figuren 2 bis 4      drei erfindungsgemäße Ausführungen.

In den Figuren sind einander entsprechende Teile mit gleichen Bezugszeichen versehen.

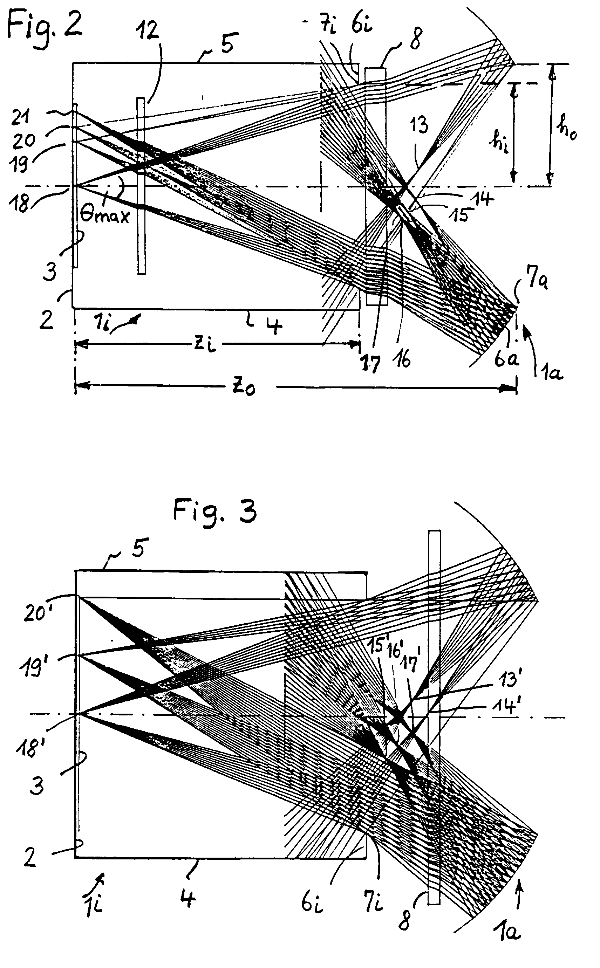

In Fig. 2 ist das innere Kälteschild mit $1_i$ bezeichnet, das eine kalte Bodenfläche 2 aufweist, die ein flächiges Detektorelement 3 trägt. An die kalte Bodenfläche 2 schließen kalte seitliche Wände 4 und 5 an, die auch eine Zylinderwand bilden können und die sich bis zu einer inneren Kaltblende $6_i$ erstrecken. Die kalte Bodenfläche mit den anschließenden seitlichen Wänden 4 und 5 und der strahleneingangsseitigen inneren Kaltblende $6_i$ mit der Öffnung $7_i$ bilden das gekühlte innere Kälteschild $1_i$, das das flache Detektorelement 3 umschließt. Die Kühlung des inneren Kälteschildes $1_i$ erfolgt durch eine nicht dargestellte Kühleinrichtung. Dabei kann lediglich die Bodenfläche 2 gekühlt sein. Es können aber auch die seitlichen Wände 4 und 5 und die innere Kalt-

blende $6_i$ gekühlt sein.

Das innere Kälteschild $1_i$ befindet sich in einem Gehäuse (Dewar), das an ein Vakuum angeschlossen ist und durch ein strahleneingangsseitiges Infrarot-strahlendurchlässiges Fenster 8 (IR-Fenster) abgeschlossen ist. In Fig. 2 ist von dem Dewar nur das IR-Fenster 8 (Abschlußscheibe des Dewar) gezeigt.

Dem inneren Kälteschild $1_i$ ist in Fig. 2 ein thermisch von dem inneren Kälteschild $1_i$ getrenntes äußeres Kälteschild la zur optischen Abschirmung von Infrarotstörstrahlen, z.B. in der Gestalt eines innenverspiegelten Hohlspiegels vorgeschaltet, der eine sphärische oder asphärische Innenfläche aufweisen kann und eine äußere Kaltblende $6_a$ bildet, die beispielsweise eine zentrisch zur optischen Achse liegende Öffnung (Loch) $7_a$ aufweist. Die Öffnung $7_a$ der äußeren Kaltblende $6_a$ bildet die Austrittspupille der vorgeschalteten, nicht dargestellten Infrarot-Optik (IR-Optik).

Die innere Kaltblende $6_i$ des inneren Kälteschildes $1_i$ wirkt als Baffle, und der Abstand $z_i$ zwischen der Bildebene auf der Oberfläche des Detektors 3 und der inneren Kaltblende $6_i$ mit der Öffnung $7_i$ kann nach den vorstehenden Bemessungsregeln minimiert, d.h. vergleichsweise wesentlich verkürzt werden (vgl. vorstehende Gleichung (6)), wobei sichergestellt ist, daß es nicht zu einer Vignettierung an den äußeren und inneren Kaltblenden kommt.

Im Inneren des inneren Kälteschildes $1_i$ befindet sich ein optischer Filter 12, der dem flachen Detektorelement 3 unmittelbar vorgeschaltet ist. Der Filter 12 kann aber auch entfallen. Derartige kalte Filter sind in der Infrarot-Technik bekannt.

Erfindungsgemäß ist das äußere Kälteschild $1_a$ so gestaltet und gegenüber dem inneren Kälteschild $1_i$ so angeordnet, daß die Kaustiken 13 bis 17 der von Punkten 18 bis 21 der Bildebene ausgehenden und von dem äußeren Kälteschild 1a durch das IR-Fenster 8 in das innere Kälteschild $1_i$ reflektierten Strahlenbüschel nahe vor, aber nicht auf dem IR-Fenster 8 liegen. Bei der erfindungsgemäßen Strahlendetektoreinrichtung sind die Parameter im Beispielsfalle etwa wie folgt gewählt:

$k_a = 2{,}0$
$k_i = z_i/2h_i = 1{,}5$
$z_a = 60$ mm
$z_i = 40$ mm
$d = 10$ mm

Der Krümmungsradius der äußeren Kaltblende $6_a$ läßt sich mittels bekannter optischer Rechenverfahren optimieren. Er weist bei der Ausführung nach Fig. 2 den Wert 27,5 auf.

Figur 3 zeigt ein weiteres Ausführungsbeispiel einer erfindungsgemäßen Infrarot-Strahlendetektoreinrichtung entsprechend Fig. 2, in der lediglich die Detektorfläche des Detektorelementes 3 und die innere Kaltblende $6_i$ mit ihrer Öffnung $7_i$ angedeutet sind. Mit 8 ist das IR-Fenster und mit $6_a$ die äußere Kaltblende bezeichnet. Die abgeänderten Parameter sind bei dieser Ausführung wie folgt gewählt:

$k_a = 2{,}0$
$k_i = z_i/2h_i = 1{,}25$
$z_a = 40$ mm
$z_i = 25$ mm
$d = 10$ mm

Die Bildpunkte 18', 19' und 20' liegen etwas hinter der Detektoroberfläche. Bei dieser Ausführung liegen die Kaustiken teilweise im IR-Fenster 8 und teilweise vor und hinter dem IR-Fenster 8 und vor der inneren Kaltblende $6_i$.

In sämtlichen Ausführungsbeispielen ist wie auch beim Stand der Technik der maximale Strahlenwinkel des zentralen Bildpunktes 18 bzw. 18' mit $\theta_{max}$ bezeichnet. Das entspricht einer optischen Öffnung von $k_{opt} = 1/2 \cot (\theta_{max})$. Für den maximalen Strahlenwinkel gilt $\theta_{max} \leq 30°$. Das entspricht einer optischen Öffnung von etwa 0,8. Hierbei weist jedoch erfindungsgemäß das innere Kälteschild $1_i$ gegenüber dem Stand der Technik vorteilhafterweise eine etwa bis zu einem Faktor 2 reduzierte Länge $z_i$ auf.

Beim Stand der Technik (Fig. 1a) beträgt die minimale axiale Länge $z_o$ des inneren Kälteschildes etwa 4d, wenn der maximale Gesamtdurchmesser des flächigen Detektorelementes 2d ist. Bei dem gleichen maximalen Gesamtdurchmesser des Detektorelementes beträgt der Abstand $z_i$ der Öffnung $7_i$ der inneren Kaltblende $6_i$ bei der Erfindung (Fig. 1b) jedoch nur etwa 2d.

Das innere Kälteschild läßt sich damit erfindungsgemäß gegenüber den bekannten Einrichtungen axial um etwa die Hälfte verkürzen.

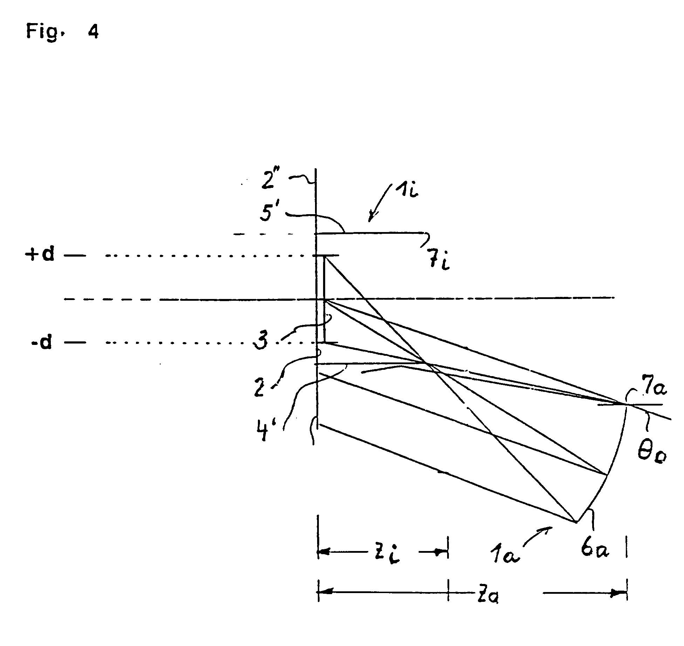

Fig. 4 zeigt eine weitere erfindungsgemäße Ausführung, die sich besonders für weit geöffnete Systeme eignet. Wenn der maximale Durchmesser des Detektors 2d ist, ist nach Fig. 4 der Abstand $z_i$ der Kaltblendenöffnung $7_i$ von der Bildebene etwa 2d. Das innere Kälteschild $1_i$ besitzt dabei eine radiale kranz- bzw. kragenartige Bodenstruktur mit gekühlten seitlichen Wandabschnitten 4' und 5' und mit beidseitig von der optischen Achse radial nach außen verlängerten gekühlten Bodenabschnitten 2' und 2", durch die der gekühlte Boden 2 des inneren Kälteschildes als Träger des Detektorelementes 3 über die seitlichen, in Achsrichtung verlaufenden Wände 4' und 5' hinaus verbreitert ist. Die innere Kaltblende $6_i$ wird hier von dem freien Öffnungsquerschnitt der seitlichen Wandabschnitte 4' und 5' gebildet. Die äußere Kaltblende 6a besteht beispielsweise aus einer torischen Spiegelfläche. Die Seitenwände 4' und 5' können einen offenen Zylinder bilden, der einseitig durch den Boden 2 abgeschlossen ist. Die überstehenden Bodenabschnitte 2' und 2" können einen Ring bilden.

In sämtlichen Ausführungsbeispielen, einschließlich der prinzipiellen Skizzen nach der Fig. 1b ist das äußere Kälteschild $1_a$ derart ausgebildet und gegenüber dem Detektorelement 3 angeordnet, daß die von Bildpunkten des optischen Bildes auf der Oberfläche des Detektorelementes ausgehenden und von dem äußeren Kälteschild $1_a$ reflektierten Strahlenbüschel nur auf gekühlte Flächen des internen Kälteschildes $1_i$

fallen. Statt des inneren Kälteschildes $1_i$ innerhalb eines Dewars (internes Kälteschild) kann auch eine extern angebrachte gekühlte Lichtfalle verwendet werden, die von dem Ort des Detektorelementes 3 entfernt seitlich versetzt angeordnet ist und beispielsweise eine Struktur entsprechend den inneren Kälteschildern $1_i$ nach Fig. 1b bis 4 aufweist, die hierbei frei von der Lage des Detektorelementes gewählt werden kann. Andererseits kann es vorteilhaft sein, das ungekühlte äußere Kälteschild $1_a$ zusammen mit dem gekühlten inneren Kälteschild $1_i$ innerhalb eines Vakuumgefäßes (Dewar) anzuordnen, wobei das äußere Kälteschild $1_a$ nicht an die Kühlvorrichtung angeschlossen ist. Ein Vorteil besteht dabei darin, daß die entstehenden Kaustiken keine Rolle in bezug auf das IR-Fenster spielen.

In sämtlichen Ausführungsbeispielen ist sichergestellt, daß von Bildpunkten auf der Detektoroberfläche ausgehende Strahlenbüschel, die von dem äußeren Kälteschild $1_a$ reflektiert werden, nicht auf das Detektorelement 3 fallen, sondern ausschließlich auf Wände des inneren Kälteschildes $1_i$, die vorzugsweise sämtlich gekühlt sind, wobei die möglicherweise entstehenden Kaustiken vorzugsweise im vom Detektorelement 3 entfernt liegenden Eintrittsbereich des inneren Kälteschildes $1_i$ mit Abstand von seinen Wänden liegen.

Die Auslegung eines optimalen Dewars erfolgt erfindungsgemäß wie folgt:

Das äußere Kälteschild $1_a$ soll verhindern, daß das Detektorelement 3 Strahlung erfaßt, die nicht aus dem gekühlten Dewar kommt. Das Detektorelement 3 soll also keine Strahlung erfassen, die innerhalb unerwünschter Raumwinkelbereiche liegt, d.h. außerhalb des äußeren Kälteschildöffnungsverhältnisses $k_a$. Anders ausgedrückt, das Detektorelement 3 soll in den unerwünschten Raumwinkelbereichen - über das äußere Kälteschild - ausschließlich auf gekühlte Flächen und im wesentlichen nicht auf sich selbst oder auf Dewarbereiche außerhalb des internen Kälteschildes $1_i$ "sehen".

Nachdem vorstehend der Abstand $z_a$ der äußeren Kaltblendenöffnung von der Bildebene (Detektoroberfläche) und das äußere Kaltblendenöffnungsverhältnis $k_a$ festgelegt sind, versucht man die optimal kleinste Länge $z_i$ des inneren Kaltschildes $1_i$ zu finden. Man nimmt einen Startwert für $z_i = z_a/2$ an und ermittelt mit der Strahldurchrechnung, ob es möglich ist, alle Strahlen, die vom Detektorelement kommen und das Loch 7a des äußeren Kälteschildes 6a verfehlen, auf die gekühlten Wände des inneren Kälteschildes $1_i$ zu richten. Trifft man dabei mit Fehlstrahlung auf das Detektorelement 3, wird $z_i$ sukzessiv verlängert, bis keine Fehlstrahlung mehr auf das Detektorelement 3 fällt. Unter paraxialen Abbildungsverhältnissen wird $z_i = z_a/2$ erreicht (vgl. Gleichung (6)).

Bei der auf diese Weise durchzuführenden Auslegung des inneren Kälteschildes $1_i$ muß die Randbedingung erfüllt sein, daß die Dewarabschlußscheibe bzw. das IR-Fenster 8 oder Bereiche hiervon nicht auf das Detektorelement 3 selbst abgebildet werden. Hierzu muß die Position des IR-Fensters 8 optimiert werden, wie es vorstehend anhand der Ausführungsbeispiele in den Fig. 1 bis 4 und der Gleichungen (1) bis (6) aufgezeigt ist.

Erfindungsgemäß weist ein inneres Kälteschild $1_i$ für einen Flächendetektor 3 eine als Baffle wirkende innere Kaltblende $6_i$ und ein äußeres Kälteschild $1_a$ eine körperliche Blende als Austrittspupille der vorgeschalteten IR-Optik auf. Das äußere Kälteschild 1a ist so beschaffen, daß die vom Detektorelement 3 wahrgenommenen Raumwinkelbereiche zwischen der Kaltblendenöffnung $7_i$ des inneren Kälteschildes $1_i$ und der Öffnung $7_a$ des äußeren Kälteschildes $1_a$ nahezu vollständig auf gekühlte Wände des inneren Kälteschildes $1_i$ gespiegelt werden. Hierzu wird der Abstand $z_i$ zwischen der Kaltblende $6_i$ des inneren Kälteschildes $1_i$ mit optimal kleinstmöglichen (effektiven) inneren Kälteschild-Öffnungsverhältnis $k_i$ und der Detektorebene (Bildebene) minimiert, während das Öffnungsverhältnis $k_a$ der äußeren Kaltblende $6_a$ maximiert wird. Es werden keine Bereiche des IR-Fensters des Dewar auf dem Detektor abgebildet. Die Kaustiken der von dem Detektorelement ausgehenden und über die verspiegelte Innenfläche des äußeren Kaltschildes reflektierten Strahlen liegen im Bereich des IR-Fensters oder vorzugsweise im Inneren des Dewar. Die verspiegelte Innenfläche des äußeren Kälteschildes $1_a$ kann sphärisch oder asphärisch sein. Dabei können mehrere gestaffelte äußere Kälteschilde vorhanden sein. Die körperliche Blende wird in diesem Falle vom äußersten, vom inneren Kälteschild $1_i$ am entferntesten liegenden Kälteschild gebildet. Die übrigen äußeren Kälteschilde und die innere Kaltblende bilden Baffles. Die Randbereiche des inneren Kälteschildes sind so bemessen (Reflexionsvermögen, Temperatur, mechanische Abmessungen), daß keine störenden Einflüsse auf den Detektor 3 verursacht werden. Es kann dabei von Vorteil sein, zwischen dem Detektorelement und der inneren Kaltblende $6_i$ des internen Kälteschildes $1_i$ ein internes Filter 12 (Hoch-/Tief-/Bandpaß) anzuordnen (Fig. 2). Das IR-Fenster 8 des Dewar kann zusätzlich oder allein vorteilhafterweise als ein solches internes Filter gestaltet sein. Die Vorderseite der inneren Kaltblende (Baffle) $6_i$ erstreckt sich vorteilhafterweise bis zur Innenseite der äußeren Außenwand des Dewar-Gehäuses.

Die Öffnung $7_i$ der inneren Kaltblende $6_i$ kann vergleichsweise zur Öffnung $7_a$ des äußeren Kälteschildes $1_a$ grob toleriert sein, was von Vorteil ist, da sich die innere Kaltblende $6_i$ innerhalb des nach außen dicht abgeschlossenen Vakuumgefäßes (Dewar) befindet. Anderseits kann es erfindungsgemäß von Vorteil sein, das äußere Kälteschild $1_a$ mit der äußeren Kaltblende $6_a$ in das Dewar zu integrieren, ohne daß es an die Kühlvorrichtung für das innere Kälteschild $1_i$ angeschlossen ist. Wenn erfindungsgemäß die Öffnung $7_a$ des äußeren Kälteschildes 1a an die Stelle der Öffnung 7 des bekannten Kälteschildes nach Fig. 1a gesetzt wird, kann das vorhandene Dewar für das bekannte Kälteschild weitgehend beibehalten werden. Ein bekanntes Dewar für ein Kälteschild nach Fig. 1a läßt sich damit erfindungsgemäß verwenden, um das axial wesentlich verkürzte innere Kälteschild $1_i$ und das vorgeschaltete äußere Kälteschild $1_a$ in dem vorhandenen Dewar ohne wesentliche Änderungen integrieren zu können. Auf diese Weise ist die Umrüstung bekannter Dewars mit Kälteschildern entsprechend Fig. 1a in erfindungsgemäße Einrichtungen bei weitgehender Übernahme der vorhandenen Raumaufteilungen mit geringem Bau- und Kostenaufwand möglich.

Die Erfindung ist nicht auf die dargestellten und/oder beschriebenen Ausführungsbeispiele beschränkt. Dem Fachmann ist hierdurch aber eine technische Lehre vermittelt, durch die er in die Lage versetzt ist, abgeänderte Ausführungen anzugeben, die im Rahmen der Erfindung liegen, wie sie durch die vorstehende Berechnung im wesentlichen festgelegt ist. So kann ein Dewar mit einer Kaltblendenöffnung $6_i$ derart gestaltet sein, daß durch einfachen Wechsel des äußeren Kälteschildes $1_a$ das Gesamtsystem mit geändertem äußeren Öffnungsverhältnissen betrieben werden kann. Das innere Kälteschild $1_i$ läßt sich auch getrennt vom Detektorelement 3 extern anordnen.

## Patentansprüche

1. Infrarot-Strahlendetektoreinrichtung mit

   - einem gekühlten Detektorelement,
   - einem das gekühlte Detektorelement von Infrarotstrahlen weitgehend abschirmenden inneren Kälteschild ($1_i$) mit einer inneren Kalblende ($6_i$),
   - einer IR-Optik zur Abbildung eines Infrarotbildes auf dem Detektorelement (3), und
   - einem in Lichtrichtung dem inneren Kälteschild ($1_i$) vorgeschalteten, von dem inneren Kälteschild thermisch getrennten äußeren Kälteschild ($1_a$) mit einer äußeren Kalblende ($6_a$),

   **dadurch gekennzeichnet,** daß

   - die IR-Optik Öffnungen ($7_i$; $7_a$) der inneren und äußeren Kaltblenden ($6_i$, $6_a$) aufweist wobei die äußere Kaltblende ($6_a$) als Austrittspupille der IR-Optik ausgebildet ist,
   - sowie, daß ein inneres Kaltblendenöffnungsverhältnis $k_i = z_i/2h_i$ mit $z_i$ für den Abstand der Bildebene von der inneren Kaltblendenöffnung ($7_i$) und $h_i$ der Randhöhe der inneren Kaltblendenöffnung ($7_i$) und
   - ein äußeres Kaltblendenöffnungsverhältnis $k_a = z_a/2h_a$ mit $z_a$ für den Abstand der Bildebene von der äußeren Kaltblendenöffnung ($7_a$) und $h_a$ der Randhöhe der äußeren Kaltblende ($6_a$)

folgende Bedingungen einhalten:

$$\frac{1}{k_{opt}} = \frac{2d}{z_a} + \frac{1}{k_a}$$

und

$$\frac{1}{2k_i} \geq \frac{1}{2k_a} + \left(\frac{1}{z_i} - \frac{1}{z_a}\right) \cdot d,$$

wobei $k_{opt}$ das Öffnungsverhältnis der Optik und d der halbe Gesamtdurchmesser des Detektorelementes ist.

2. Einrichtung nach Anspruch 1, dadurch gekennzeichnet, daß bei einem maximalen Strahlenwinkel $\theta_{max} \leq 30°$ und bei einem maximalen Gesamtdurchmesser von 2d des Detektorelements (3) der Bildabstand ($z_i$) von der inneren Kaltblendenöffnung ($7_i$) etwa d bis 2d beträgt.

3. Einrichtung nach Anspruch 1 oder 2, dadurch gekennzeichnet, daß das innere und das äußere Kälteschild ($1_i$, $1_a$) mit einer die Austrittspupille der Optik bildenden äußeren Kälteschildöffnung ($7_a$) in einem Vakuumgefäß integriert sind, das strahleneintrittseitig von einem IR-Fenster (8) abgeschlossen ist, welches der äußeren Kälteschildöffnung vorgelagert ist, wobei $z_i \geq 1/2z_a$ gewählt ist.

4. Einrichtung nach Anspruch 1, dadurch gekennzeichnet, daß das innere Kaltblendenöffnungsverhältnis $k_i = z_i/2h_i$ etwa 1,25 bis 1,5 und das äußere Kaltblendenöffnungsverhältnis $k_a = z_a/2h_a$ etwa 2 ist.

5. Einrichtung nach Anspruch 4, dadurch gekennzeichnet, daß der innere Kaltblendenöffnungsabstand ($z_i$) von der Bildebene etwa 25 mm bis 40 mm und der äußere Kaltblendenöffnungsabstand ($z_a$) von der Bildebene etwa 40 bis 60 mm ist.

6. Einrichtung nach den Ansprüchen 4 und 5, dadurch gekennzeichnet, daß die maximale Bildhöhe (d) in der Detektorebene etwa 10 mm ist.

7. Einrichtung nach einem der vorstehenden Ansprüche, dadurch gekennzeichnet, daß die Kaustiken (13-17, 13'-17') der von Bildpunkten (18-21; 18'-20') auf der Detektoroberfläche ausgehenden und von dem äußeren Kälteschild ($1_a$) gespiegelten Strahlen im Bereich der Öffnung ($7_i$) der inneren Kaltblende ($6_i$) mit Abstand von den Wänden (4, 5) des inneren Kälteschildes ($1_i$) liegen.

8. Einrichtung nach einem der vorstehenden Ansprüche, dadurch gekennzeichnet, daß mehrere hintereinander gestaffelt angeordnete äußere Kälteschilde vorhanden sind, wobei das äußerste Kälteschild die körperliche Blende als Austrittspupille bildet und die übrigen äußeren Kälteschilde Baffle sind.

9. Einrichtung nach einem der vorstehenden Ansprüche, dadurch gekennzeichnet, daß das die Austrittspupille bildende äußere Kälteschild ($1_i$) eine sphärische oder asphärische verspiegelte Innenfläche aufweist.

10. Einrichtung nach Anspruch 9, dadurch gekennzeichnet, daß der Krümmungsradius des äußeren Kälteschildes ($1_a$) etwa 22,5 mm beträgt.

11. Einrichtung nach Anspruch 1, dadurch gekennzeichnet, daß der Abstand ($z_i$) des Detektorelements (3) von der Öffnung ($7_i$) des inneren Kälteschildes ($6_i$) etwa d beträgt, wobei der das Detektorelement (3) tragende Boden radial äußere Bodenabschnitte aufweist, die die axialen seitlichen Wände des Kälteschildes kranz- bzw. kragenförmig nach außen überragen und der radiale Durchmesser des Bodenabschnittes etwa d beträgt.

12. Einrichtung nach Anspruch 1, dadurch gekennzeichnet, daß das innere Kälteschild ($1_i$) getrennt von der Bodenfläche (2) des Detektorelementes (3) extern angeordnet ist und daß das äußere Kälteschild ($1_a$) asymmetrisch zur optischen Achse angeordnet ist.

13. Einrichtung nach einem der vorstehenden Ansprüche, dadurch gekennzeichnet, daß dem Detektorelement (3) außerhalb der Kaustiken (13-17, 13'-17') ein Filter (12) vorgeschaltet ist.

14. Einrichtung nach Anspruch 13, dadurch gekennzeichnet, daß das IR-Fenster als Filter ausgebildet ist.

**Claims**

1. Infrared radiation detector with

   - a cooled detector element,

   - an internal cold shield ($1_i$), extensively screening the cooled detector element from infrared rays, with an internal cold screen ($6_i$),

   - an IR optical system for forming an infrared image on the detector member (3), and

   - an external cold shield ($1_a$) preceding the internal cold shield ($1_i$) in the direction of the light, and thermally separated from the internal cold shield, with an external cooled screen ($6_a$),

characterised in that

   - the IR optical system has apertures ($7_i$, $7_a$) of the internal and external cold shields ($6_i$, $6_a$), the external cold shield ($6_a$) being in the form of an output diaphragm for the IR optical system, and in that

   - there is an internal cold screen aperture ratio $k_i = z_i/2h_i$ with $z_i$ spacing between the image plane and the internal cold screen aperture ($7_i$), and $h_i$ being the edge height of the internal cold screen aperture ($7_i$), and

   - there is an external cold screen aperture ratio $k_a = z_a/2h_a$ with $z_a$ for the spacing between the image plane and the external cold screen aperture ($7_a$), and $h_a$ is the edge height of the external cold screen ($6_a$), the following conditions being observed:

$$\frac{1}{k_{opt}} = \frac{2d}{z_a} + \frac{1}{k_a}$$

und

$$\frac{1}{2k_i} \geq \frac{1}{2k_a} + \left(\frac{1}{z_i} - \frac{1}{z_a}\right) \cdot d,$$

$k_{opt}$ being the aperture ratio of the optical system and d being half the overall diameter of the detector element.

2. Arrangement according to claim 1, characterised in that, with a maximum beam angle $\theta_{max} \leq 30°$, and with a maximum overall diameter of 2d of the detector element (3) the spacing ($z_i$) between the image and the internal cold screen aperture ($7_i$) comes to about d to 2d.

3. Arrangement according to claim 1 or 2, characterised in that the internal and the external cold shield ($1_i$, $1_a$) are integrated with an external cold shield aperture ($7_a$) forming the output diaphragm of the optical system, in a vacuum vessel, which is closed on the beam entry side by an IR window (8), which precedes the external cold screen aperture, $z_i \leq \frac{1}{2}z_a$ being selected.

4. Arrangement according to claim 1, characterised in that the internal cold screen aperture ratio $k_i = z_i/2h_i$ of about 1.25 to 1.5, and the external cold screen aperture ratio $k_a = z_a/2h_a$ is about z.

**5.** Arrangement according to claim 4, characterised in that the internal cold screen aperture spacing ($z_i$) from the image plane is about 25 mm to 40 mm, and the external cold screen aperture spacing ($z_a$) is about 40 to 60 mm from the image plane.

**6.** Arrangement according to claims 4 and 5, characterised in that the maximum image height (d) in the detector plane is about 10 mm.

**7.** Arrangement according to one of the preceding claims, characterised in that the caustics (13-17, 13'-17') of the beams emerging from image points (18-21; 18'-20') on the detector surface and reflected by the external cold screen ($1_a$) lie in the area of the aperture ($7_i$) of the internal cold screen ($6_i$) with a spacing from the walls (4, 5) of the internal cold shield ($1_i$).

**8.** Arrangement according to one of the preceding claims, characterised in that there are present a plurality of external cold shields located in a staggered fashion one behind the other, the externalmost cold shield forming the physical screen as an output diaphragm, and the other external cold shields being baffles.

**9.** Arrangement according to one of the preceding claims, characterised in that the external cold shield ($1_i$) forming the output diaphragm has a spherical or aspherical reflective internal surface.

**10.** Arrangement according to claim 9, characterised in that the radius of curvature of the external cold shield ($1_a$) comes to about 22.5 mm.

**11.** Arrangement according to claim 1, characterised in that the spacing ($z_i$) between the detector element (3) and the aperture ($7_i$) of the internal cold shield ($6_i$) comes to about d, the base carrying the detector element (3) having radial external base sections, which project in a crown or collar configuration over the axial lateral walls of the cold shield, and the radial diameter of the base section comes to about d.

**12.** Arrangement according to claim 1, characterised in that the internal cold shield ($1_i$) is located externally separately from the base surface (2) of the detector element (3), and in that the external cold shield ($1_a$) is located asymmetrical to the optical axis.

**13.** Arrangement according to one of the preceding claims, characterised in that a filter (12) precedes the detector element (3) outwith the caustics (13-17, 13'-l7').

**14.** Arrangement according to claim 13, characterised in that the IR window is in the form of a filter.

# Revendications

**1.** Dispositif détecteur de rayonnements infrarouges comprenant

- un élément détecteur refroidi,
- une plaque frigorifique intérieure ($1_i$) qui protège dans une large mesure des rayonnements infrarouges l'élément détecteur refroidi et qui comporte un diaphragme froid intérieur ($6_i$),
- un objectif IR servant à former une image infrarouge sur l'élément détecteur (3) et
- une plaque frigorifique extérieure ($1_a$) qui est disposée en amont de la plaque frigorifique intérieure ($1_i$) suivant la direction de la lumière et est séparée thermiquement de la plaque frigorifique intérieure et qui comporte un diaphragme froid extérieur ($6_a$),

   caractérisé

- en ce que l'objectif IR comporte des ouvertures ($7_i$, $7_a$) des diaphragme froid intérieur et diaphragme froid extérieur ($6_i$, $6_a$), le diaphragme froid extérieur ($6_a$) étant réalisé sous forme d'une pupille de sortie de l'objectif IR,
- et en ce qu'une raison d'ouverture de diaphragme froid intérieur $k_i = z_i/2h_i$, avec $z_i$ pour la distance du plan image à l'ouverture de diaphragme froid intérieur ($7_i$) et $h_i$ pour la hauteur de bord de l'ouverture de diaphragme froid intérieur ($7_i$) et
- une raison d'ouverture de diaphragme froid extérieur $k_a = z_a/2h_a$, avec $z_a$ pour la distance du plan image à l'ouverture de diaphragme froid extérieur ($7_a$) et $h_a$ pour la hauteur de bord du diaphragme froid extérieur ($6_a$)

   respectent les conditions suivantes :

$$1/k_{obj} = 2d/z_a + 1/k_a$$

et

$$1/2k_i^3\ 1/2k_a + (1/z_i - 1/z_a) - d,$$

   $k_{obj}$ étant la raison d'ouverture de l'objectif et d le demi-diamètre total de l'élément détecteur.

**2.** Dispositif suivant la revendication 1, caractérisé en ce que, pour un angle maximal de faisceau qmax £ 30° et pour un diamètre total maximal 2d de l'élément détecteur (3), la distance image ($z_i$) à partir de l'ouverture de diaphragme froid intérieur ($7_i$) vaut environ d à 2d.

3. Dispositif suivant la revendication 1 ou 2, caractérisé en ce que les plaque frigorifique intérieure et plaque frigorifique extérieure ($1_i$, $1_a$) sont intégrées avec une ouverture de plaque frigorifique extérieure ($7_a$) formant la pupille de sortie de l'objectif dans un vase sous vide qui est fermé du côté d'entrée de rayonnement par une fenêtre IR (8) qui est disposée en amont de l'ouverture de plaque frigorifique extérieure, $z_i$ étant choisi $3$ $1/2z_a$.

4. Dispositif suivant la revendication 1, caractérisé en ce que la raison d'ouverture de diaphragme froid intérieur $k_i = z_i/2h_i$ vaut environ 1,25 à 1,5 et la raison d'ouverture de diaphragme froid extérieur $k_a = z_a/2h_a$ vaut environ 2.

5. Dispositif suivant la revendication 4, caractérisé en ce que la distance d'ouverture de diaphragme froid intérieur ($z_i$) à partir du plan image vaut environ 25 mm à 40 mm et la distance d'ouverture de diaphragme froid extérieur ($z_a$) à partir du plan image vaut environ 40 à 60 mm.

6. Dispositif suivant les revendications 4 et 5, caractérisé en ce que la hauteur maximale d'image (d) dans le plan de détecteur vaut environ 10 mm.

7. Dispositif suivant l'une des revendications précédentes, caractérisée en ce que les caustiques (13-17, 13'-17') des faisceaux issus des points image (18-21 ; 18'-20') sur la surface de détecteur et réfléchis par la plaque frigorifique extérieure ($1_a$) sont situées, dans la zone de l'ouverture ($7_i$) du diaphragme froid intérieur ($6_i$), à distance des parois (4, 5) de la plaque frigorifique intérieure ($1_i$).

8. Dispositif suivant l'une des revendications précédentes, caractérisé en ce qu'il est prévu plusieurs plaques frigorifiques extérieures disposées d'une manière échelonnée l'une derrière l'autre, la plaque frigorifique la plus extérieure formant le diaphragme matériel servant de pupille de sortie et les autres plaques frigorifiques extérieures étant des baffles.

9. Dispositif suivant l'une des revendications précédentes, caractérisé en ce que la plaque frigorifique extérieure ($1_i$) formant la pupille de sortie comporte une surface intérieure métallisée sphérique ou asphérique.

10. Dispositif suivant la revendication 9, caractérisé en ce que le rayon de courbure de la plaque frigorifique extérieure ($1_a$) vaut environ 22,5 mm.

11. Dispositif suivant la revendication 1, caractérisé en ce que la distance ($z_i$) de l'élément détecteur (3) à partir de l'ouverture ($7_i$) de la plaque frigorifique intérieure ($6_i$) vaut environ d, tandis que le fond portant l'élément détecteur (3) comporte des sections de fond radialement extérieures qui font saillie vers l'extérieur au-delà des parois latérales axiales de la plaque frigorifique suivant une forme de couronne ou de collerette et que le diamètre radial de la section de fond vaut environ d.

12. Dispositif suivant la revendication 1, caractérisé en ce que la plaque frigorifique intérieure ($1_i$) est disposée de manière externe en étant séparée de la surface de fond (2) de l'élément détecteur (3) et en ce que la plaque frigorifique extérieure ($1_a$) est disposée d'une manière asymétrique par rapport à l'axe optique.

13. Dispositif suivant l'une des revendications précédentes. caractérisé en ce qu'un filtre (12) est disposé en amont de l'élément détecteur (3) à l'extérieur des caustiques (13-17, 13'-17').

14. Dispositif suivant la revendication 13, caractérisé en ce que la fenêtre IR est réalisée sous forme d'un filtre.

Fig. 1a

Fig. 1b

Fig. 2

Fig. 3

Fig. 4